Europäisches Patentamt

European Patent Office

Office européen des brevets

(11) Publication number: **0 194 950 B1**

# EUROPEAN PATENT SPECIFICATION

(45) Date of publication of patent specification: **27.05.92**  (51) Int. Cl.5: **H01L 23/52**, H01L 21/90

(21) Application number: **86400551.7**

(22) Date of filing: **14.03.86**

(54) **High temperature interconnect system for an integrated circuit.**

(30) Priority: **15.03.85 US 712589**

(43) Date of publication of application:
**17.09.86 Bulletin 86/38**

(45) Publication of the grant of the patent:
**27.05.92 Bulletin 92/22**

(84) Designated Contracting States:
**DE FR GB IT NL**

(56) References cited:
**EP-A- 0 174 773**
**WO-A-82/03948**
**FR-A- 2 238 249**

**EXTENDE ABSTRACTS, vol. 81-2, October 1981, pages 864-865, Pennington, New Jersey, US; I. SUNI et al.: "Thermal stability of titanium and hafnium nitride thin films in contact with metallic overlayers investigated by backscattering"**

**THIN SOLID FILMS, vol. 119, no. 1, September 1984, pages 23-30, Lausanne, Switzerland; J.R. SHAPPIRIO et al.: "Resistivity, oxidation kinetics and diffusion barrier properties of thin film ZrB2"**

(73) Proprietor: **FAIRCHILD SEMICONDUCTOR CORPORATION**
**10400 Ridgeview Court P.O. Box 1500**
**Cupertino, California 95014(US)**

(72) Inventor: **Thomas, Michael**
**20718 Garden Crest Court**
**Cupertino California 95074(US)**

(74) Representative: **Sparing Röhl Henseler Patentanwälte European Patent Attorneys**
**Rethelstrasse 123**
**W-4000 Düsseldorf 1(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

THIN SOLID FILMS, vol. 96, no. 4, October 1982, pages 317-326, Lausanne, CH; R.S. NOWICKI et al.: "General aspects of barrier layers for very-large-scale integration applications. II. practice"

APPLIED PHYSICS LETTERS, vol. 36, no. 6, March 1980, pages 456-458, New York, US; M. WITTMER "TiN and TaN as diffusion barriers in metallizations to silicon semiconductor devices"

JOURNAL OF APPLIED PHYSICS, vol. 53, no. 2, February 1982, pages 1007-1012, New York, US; M. WITTMER "Interfacial reactions between aluminium and transition-metal nitride and carbide films"

JOURNAL OF APPLIED PHYSICS, vol. 52, no. 6, June 1981, pages 4297-4299, New York, US; N.W. CHEUNG et al.: "Thermal stability of titanium nitride for shallow junction solar cell contacts"

## Description

The present invention relates generally to construction of semiconductor integrated circuit devices and more particularly to constructions which inhibit silicon transport during high temperature processing and/or operation of such devices.

Semiconductor integrated circuits are commonly fabricated utilizing aluminium and aluminium alloy metallization to create device contacts and interconnects. The article of M. Wittmer, published in Journal of Applied Physics, Vol. 53(2), 1982, pages 1007-1012, is directed to the development of high-temperature contact constructures for silicon semiconductor devices comprising a refractory barrier layer and a top Al layer. Thus, a non-refractory metal, that is aluminium, is used for the metallization. This document clearly implies that such "soft" metals are required in order to have a satisfactorily performing device. Because of the use of these aluminium and aluminium alloy metallization techniques, it is imperative that the device not be practically exposed to temperatures in excess of approximately 500°C. Exposure to higher temperatures would cause the metallization to hillock, melt or substantially react with other materials in the structure and thereby degrade or destroy the device. However, it is desirable to construct devices where the interconnect is conductively coupled to silicon and is capable of withstanding high substrate temperatures, for example in the order of 550°C to 1000°C, since such high temperatures are utilized in various processing techniques such as planarization utilizing PVX reflow.

Heretofore, refractory metals having very high melting points, such as tungsten and molybdenum, could not be used as interconnects because these metals can react with Si at high temperatures, forming silicide phases in the contact region. Upon formation, these silicides have higher resistivities than the parent metals and also consume silicon in the contact regions which will eventually destroy the device. In the past, MOS technology has been able to use refractory metals of tungsten and molybdenum as interconnects to gate oxides at elevated temperatures, in the range of 900°C to 1000°C; but, such refractory metal interconnects are used to control the potential of gates via a field effect, and, as such, they are exclusively in contact with $SiO_2$ with which they are stable. In this case, these materials are not directly coupled to the underlying silicon and constrain their use in bipolar and MOS applications at high temperatures.

At present, metal barrier layers do exist in interconnect schemes which use PtSi/Ti:W/ Al-Si. However, these structures are unstable after short exposure at temperatures in the range of 500° to 550°C in which the Al-Si reacts with the Ti:W barrier layer and eventually attacks the PtSi phase and the underlying contact. Other recent work has investigated the use of titanium and zirconium nitrides as barriers with Al metallizations and stability to 600°C has been observed. From the article of H. Suni et al, published in Extended Abstracts, Vol. 81-2 (1982, 10) pages 456-458, investigations concerning TiN and HfN barrier layers formed on silicon substrates are known. Disclosed is the utilization of refractory metal nitride as diffusion barriers between contact metal and silicon substrate. As contact metals gold, palladium or copper are discussed. The nitride layer/metal combination fails at relatively low temperatures again. Further, the reactivity of Al with these materials eventually breaks down the barrier with subsequent attack of the underlying silicon. Although its resistivity is lower than other refractory materials by approximately a factor of 2, the melting point and rapid reactivity of aluminium with most materials at relatively low temperatures makes it unattractive for high temperature applications. This is where the application of the refractory metal or refractory metal compound with good stability over a barrier layer can be used to great advantage in high temperature processing, for example that which implements reflow planarization. It is therefore advantageous to provide a semiconductor device structure which includes an interconnect system which can make electrical contact with silicon and which remains stable at elevated operating and/or processing temperatures.

In the article of N.W. Cheung et al., published in Journal of Applied Physics, Vol. 52(6), 1981, pages 4297-4299, a three-layer metallization scheme is disclosed which uses a TiN barrier layer covered by a Ti layer covered by an Ag layer. The Ti layer is used to improve the adhesion between the Ag and the TiN. As the major electrical conductor a 4 micrometer thick Ag layer is utilized so that the resistance across the TiN thickness contributes negligibly to Rs. Accordingly, the Ag layer is essential to the process in order to obtain an acceptably low series resistance. A high conductivity metal such as Al, Au or Cu is required for the metallization in order to obtain satisfactory results.

Thus, Au is required over the refractory metal in order to provide a reasonable series resistance and that the refractory metal over the barrier layer is only provided to provide better contact between the metallization layer (Au) and the barrier layer. In fact, the need for an additional layer over the refractory metal layer is taught. The provision of an extra process step not only increases the cost of the device, but tends to lower the yield, thus further increasing the cost of the device.

FR 22 38 249 discloses a technique for forming a barrier layer and an interconnect comprising a refractory metal nitride.

In producing the barrier layer, it is necessary to have the nitride in order to prevent the reaction between the metals and the underlying silicon. However, the utilization of the nitride for the interconnects produces interconnects of higher resistance than desired.

Finally, the article of J.R. Shappirio et al., published in Thin Solid Films, Vol. 119, 1984, pages 23-3o, discloses attractive properties of ZrBz for potential application as barrier layer and interconnect metallization. Again, overlying aluminium metallization is used.

In addition to the desirability of providing semiconductor devices having interconnect systems which are capable of withstanding elevated processing and operating temperatures, it should be noted that as the dimensions of the emitter contacts decrease, current crowding occurs in the contact regions. This effect can increase the probability of junction spiking due to Al migration into the emitter or failure of the interconnect due directly to electromigration. Consequently, it is also advantageous to provide a semiconductor interconnect structure which would alleviate these problems.

It is further advantageous to develop self aligned barrier structures to aid in the definition of tighter contact geometries and provide etch stops to dry plasma and wet chemical processes during interconnect definition which do not allow the etchant to see the underlying silicon.

It is a general object of the present invention to provide a semiconductor device with a new high temperature interconnect system.

This and other objects of the invention are attained, in accordance with one aspect of the invention, by a method of fabricating a high temperature interconnect structure for electrically connecting doped regions in a silicon substrate of an integrated circuit device, said method comprising the steps of: a) creating contact regions on a surface of said device, each contact region exposing at least a portion of an underlying doped region; b) disposing an electrically conductive barrier layer into said contact regions and electrically contacting said underlying doped regions, said barrier layer comprising a material selected from the group consisting of a refractory metal nitride, refractory metal boride and refractory metal carbide; c) disposing an electrically conductive interconnect layer over said surface into said contact regions and electrically contacting said barrier layers disposed therein, said interconnect layer consisting in a refractory metal; and d) forming said interconnect layer into interconnects for electrically interconnecting said doped regions in a predetermined pattern, no other metal being further provided to form said interconnects.

Yet another aspect of the present invention is to provide a semiconductor integrated circuit device including a silicon substrate having a predetermined pattern of doped regions formed therein and contact regions disposed on a surface of said device, each contact region exposing at least a portion of an underlying doped region, means for electrically interconnecting said doped regions, electrically conductive barrier means disposed in said contact regions, said barrier means including a barrier layer comprising a material selected from the group consisting of a refractory metal nitride, refractory metal boride and refractory metal carbide, and said means for electrically interconnecting said doped regions includes a system of electrical interconnects consisting in a refractory metal for electrically interconnecting said doped regions through said barrier layers in said contact regions in accordance with a predetermined pattern, no other metal being further provided to form said interconnects.

In a preferred embodiment, it is desirable to remove any process induced variations in topography such as via holes created during processing for interconnections between levels of metallization. To do this, posts can be used to great advantage. Such posts eliminate the need to have step coverage by second or higher levels of metallization into via holes cut in the insulating material. This greatly enhances the reliability of the metallization integrity, because it eliminates thinning of the metal as it steps into the via hole. That is, no via hole is created. Instead a post connecting a lower layer of metallization to an upper layer of metallization is formed. This post is surrounded by insulating material which is etched back to expose the top of the post. This leaves a planarized surface upon which the upper layer of metallization can be formed thereby contacting the top of the metal post and forming an interconnect to the lower layer.

Other objects, features and advantages of the present invention will be more fully apparent from the following detailed description of the preferred embodiment, the appended claims and the accompanying drawings.

Brief Description Of The Drawings

Figure 1 is a diagrammatic cross-sectional representation of the processing stages of a preferred method for constructing a device in accordance with the present invention.

Figure 2 is a diagrammatic cross-sectional representation of the processing stages of an alternate preferred method for constructing a device in accordance with the present invention.

Figure 3 is a diagrammatic cross-sectional representation of the processing stages of yet another alternate preferred method for constructing a device in accordance with the present invention.

Figure 4 is a diagrammatic cross-sectional representation of the processing stages of still another alternate preferred method for constructing a device in accordance with the present invention.

Figure 5 is a diagrammatic cross-sectional representation of the processing stages of an additional alternate preferred method for constructing a device in accordance with the present invention.

Figure 6 is a diagrammatic cross-sectional representation of the processing stages of still another alternate preferred method for constructing a device in accordance with the present invention.

Figure 7 is a diagrammatic cross-sectional representation of the processing stages of a preferred method for constructing a device having a multi-level intercell structure in accordance with the present invention.

Figure 8 depicts Auger depth profiles of one embodiment of a structure utilizing a silicon transport barrier in accordance with the present invention, Figure 8(a) depicting the depth profile of the structure before, and Figure 8(b) after, heating the structure.

## Detailed Description Of The Preferred Embodiment

Although specific forms of the invention have been selected for illustration in the drawings, and the following description is drawn in specific terms for the purpose of describing these forms of the invention, this description is not intended to limit the scope of the invention which is defined in the appended claims.

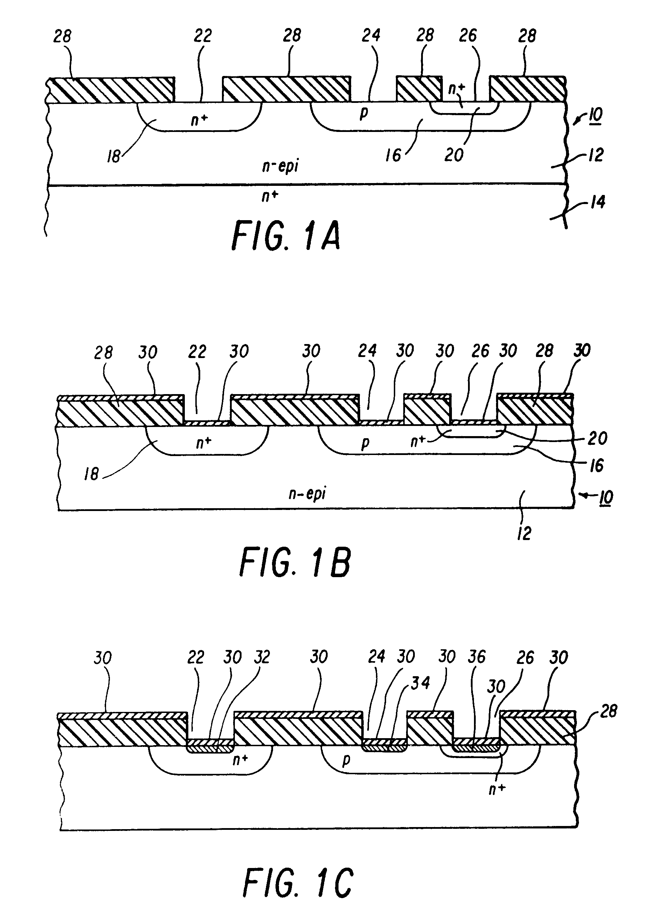

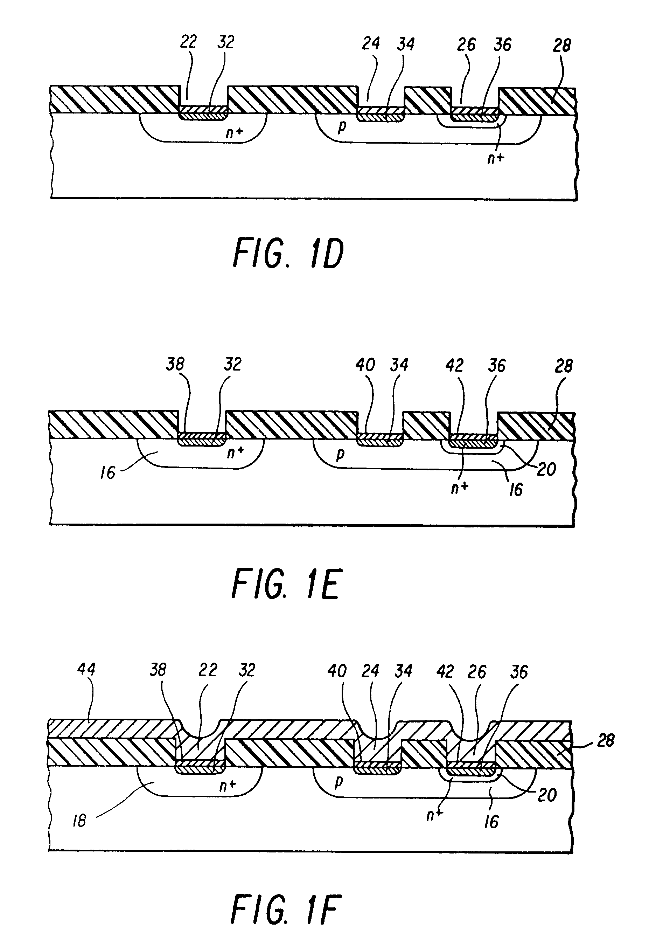

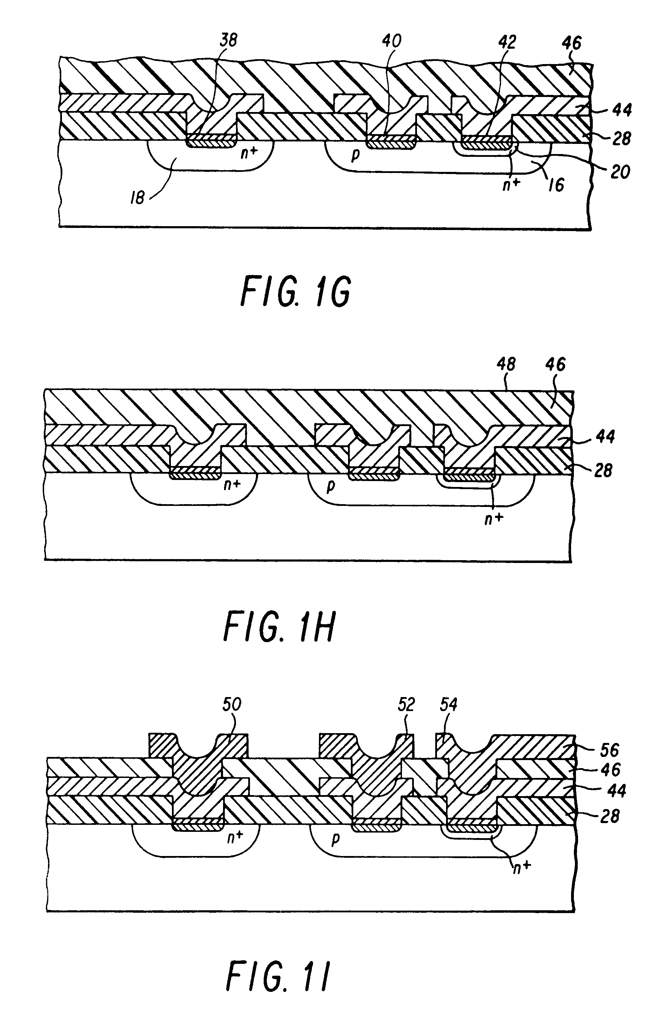

Referring to Figure 1 and particularly to Figure 1A, there is shown in diagrammatic cross-sectional form, a bipolar transistor device, generally designated 10, which has been fabricated to the point at which metal contacts are to be formed. The bipolar transistor device 10 includes an n- epi layer 12 on an n+ substrate 14. The n- epi layer 12 has a p region 16 and a n+ region 18 formed therein. The p region 16 has an n+ region 20 formed therein. Contact regions 22, 24 and 26 are created over the n+ 18, p 16 and n+ 20 regions respectively by forming apertures in a silicon dioxide layer 28 which has been formed over the upper surface of the n- epi layer 12 as well as the n+ 18, p 16 and n+ 20 regions formed therein.

It should be noted that the bipolar device structure selected here is an example which has been chosen to assist in setting forth the detailed description of the present invention. However, it would be equally valid to use other MOS or diode structures to demonstrate embodiments of this invention and the use in such other structures is deemed to be within the scope and contemplation of the present invention.

Referring now to Figure 1B, a very thin layer 30 (preferably on the order of 200Å to 500Å in thickness) of a refractory metal, preferably titanium, zirconium, or hafnium is formed in the upper contact regions 22, 24 and 26 as well as on the upper surfaces of the silicon dioxide layer 28. It is preferred that the refractory metal layer 30 be formed into the contact regions and over the silicon dioxide surface with poor step coverage for reasons which will be subsequently described. Consequently, it is preferred that the refractory metal layer 30 be formed for example using electron beam evaporation of the refractory metal at an incidence angle perpendicular to the surface. Typical power to gun is 2KW at $1 \times 10^{-6}$ torr or better with a rate between 5 and 50° per second. Although electron beam deposition is preferable, chemical vapor deposition, sputtering, physical evaporation or ion beam deposition could also be used to deposit the refractory metal layer 30.

Referring now to Figure 1C, the structure is heated in an ambient of high purity hydrogen or argon or vacuum at an elevated temperature in the range of from approximately 600°C to approximately 1000°C, for a period of time ranging from approximately a few seconds to 15 minutes in order to form metal disilicide regions 32, 34 and 36 within the contact regions 22, 24 and 26 respectively. The silicide transformation process can be accomplished using standard heat treating furnaces or rapid isothermal annealing. Since silicon is the major diffusing species in the silicide formation process, it is important to control the processing times at elevated temperatures in order to restrict the flow of silicon from the immediate vicinity of the contact regions. If the reaction conditions are not controlled, large amounts of silicon will be removed from the doped junctions in the contact holes and greatly modify their desired dimensions and integrity. By purposely introducing poor step coverage during deposition of the refractory metal layer 30 prior to heat treatment, it is possible to more favorably localize the silicide reaction in the contact. Although this process is preferred, with proper control of the heat treatment cycle required to form the silicide phase, chemical vapor deposition or sputtering are also suitable processes for the deposition of the refractory metal layer 30 as previously stated.

The structure ($TiSi_2$ with unreacted Ti in the fields for example) is placed in a selective chemical etchant, for example, hydrogen peroxide/ammonium hydroxide (3:1 parts by volume) which attacks the unreacted refractory metal (Ti) while leaving the metal disilicide regions 32, 34 and 36, within the contact regions 22, 24 and 26 respectively, intact as shown in Figure 1D.

Referring to Figure 1E, the structure is then sputter cleaned in an argon ambient to remove any surface oxide formed on the disilicide phase prior to exposing the structure to a high temperature ambient of high purity nitrogen, boron, or carbon bearing species, or by physically depositing boron or carbon bearing compounds, in order to convert the exposed surfaces of the metal disilicide regions 32, 34 and 36 to a metal nitride, metal boride, or metal carbide respectively thereby forming barrier layers 38, 40 and 42. The temperature range for these reactions is typically 600°C to 1000°C. For example, the exposed surfaces can be converted to titanium nitride by exposing titanium disilicide to nitrogen at a temperature of about 850°C for approximately one hour. Low energy ion implantation of nitrogen, boron, or carbon into the contact regions followed by a high temperature thermal cycle can also be used to form the barrier layers 38, 40 and 42 above the silicide layers 32, 34 and 36 respectively. Typical implantation energies for these species range from hundreds to tens of thousands of electron volts depending on the effective cross-section of the elements in the contact region.

Note that the process for forming the barriers results in the barrier layers 38, 40 and 42 being self aligned with the silicide layers 32, 34 and 36.

These newly formed layers 38, 40 and 42, which possess metallic properties, act as diffusion barriers to silicon from the underlying junctions 16, 18 and 20 respectively. In most cases, refractory metal nitrides, borides, or carbides have been found to be stable after intimate contact with refractory metals or disilicides at high temperatures. Although a ternary or quarternary analysis is required in order to determine the absolute stability of the barrier layer material, in many cases, the kinetics of transformation are so slow that for practical device applications (up to 1 to 2 hours at elevated device temperatures of 950°C to 1000°C), the material couple can be considered stable whether or not the thermodynamics strictly dictate a stable couple. Examples of this stability will be shown subsequently.

Referring to Figure 1F, a refractory metal layer 44, which will be used to generate interconnects, is deposited over the silicon dioxide layer 28 into the contact regions 22, 24 and 26 over the metal nitride, metal boride or metal carbide barrier layers 38, 40 and 42. It is preferable that the refractory metal possess low resistivity, preferably 10 micro-ohm centimeter or less, but for other device applications resistivities in the hundreds of micro-ohm centimeters should also be acceptable. From a bipolar device viewpoint, the most desirable refractory metals would be tungsten or molybdenum which possess resistivities on the order of 5 to 10 micro-ohm centimeters under ideal conditions. A series of possible combinations of barrier layer structures and interconnect metallizations is shown in Table 1.

## Table I
## Preferred Materials for High Temperature Interconnects
### Barrier Layers

| Nitrides | Borides | Carbides |
|---|---|---|
| HfN | $HfB_2$ | HfC |
| ZrN | $ZrB_2$ | ZrC |
| TiN | $TiB_2$ | TiC |
| TaN | $TaB_2$ | TaC |
| NbN | $NbB_2$ | NbC |
| VN | $VB_2$ | VC |
| -- | -- | $WC, W_2C$ |
| -- | -- | $MoC, Mo_2C$ |
| $CR_2N$ | $CrB_2$ | $Cr_3C_2$ |

### Interconnects

Tungsten

Molybdenum

$WSi_2$, $MoSi_2$, $TaSi_2$, $NbSi_2$, $ZrSi_2$, $TiSi_2$, $VSi_2$, $CrSi_2$

In bipolar applications where the overall sheet resistivity of the interconnect must be as low as possible, the refractory metal interconnects would preferably be 1.5 to 3 times greater in thickness than the replaced aluminum. However, for many MOS device applications where the contact resistivity dominates the overall interconnects resistance, thin layers of refractory metals on the order of thousands of angstroms can be used.

Referring to Figure 1G, an interconnect pattern is defined in the refractory metal layer 44 utilizing, for example, standard plasma etching techniques. In the preferred process, a layer of photoresist is spun onto the refractory layer 44 then exposed and developed to define the desired interconnect pattern. The refractory metal layer is then dry etched with a flourine or chlorine based plasma which selectively attacks the metal. Misalignment errors over the contact holes will not be critical since the relative etch ratio of the underlying barrier layer to refractory metal interconnect layer is small. The nitride, boride and carbide materials of barrier layers 38, 40 and 42 will protect the underlying doped silicon junctions 18, 16 end 20 respectively.

As shown in Figure 1G, the structure is coated with a layer of glass 46, preferably phosphovapox glass (PVX), which layer is thicker than the layer of the refractory metal 44 which is used to define the interconnects. The entire structure is then heated to a high temperature in the range of 800°C to 1050°C, to enable the glass to flow under surface tension forces in order to smooth the surface topography of the structure as is shown in Figure 1H.

Once the upper surface 48 of the glass layer 46 is substantially planarized as shown in Figure 1H, via aperture are etched in layer 46. The via apertures expose the underlying refractory metal interconnect layer 44 at predetermined locations. A refractory material layer is deposited onto the planarized surface 48 into the via apertures thereby contacting the underlying interconnect layer 44 at the aforementioned predetermined locations. The refractory metal is then formed into a predetermined pattern of interconnects 56 using, for example, standard plasma etching techniques previously described. This enables the formation of an additional interconnect layer 56 as shown in Figure 1I. By repetatively depositing a glass layer, reflowing it, and opening apertures which make connections between subsequent metal layers possible, one can build a vertical multi-level interconnect structure with a large number of metal layers which enables a more efficient utilization of all the transistors on an integrated circuit device.

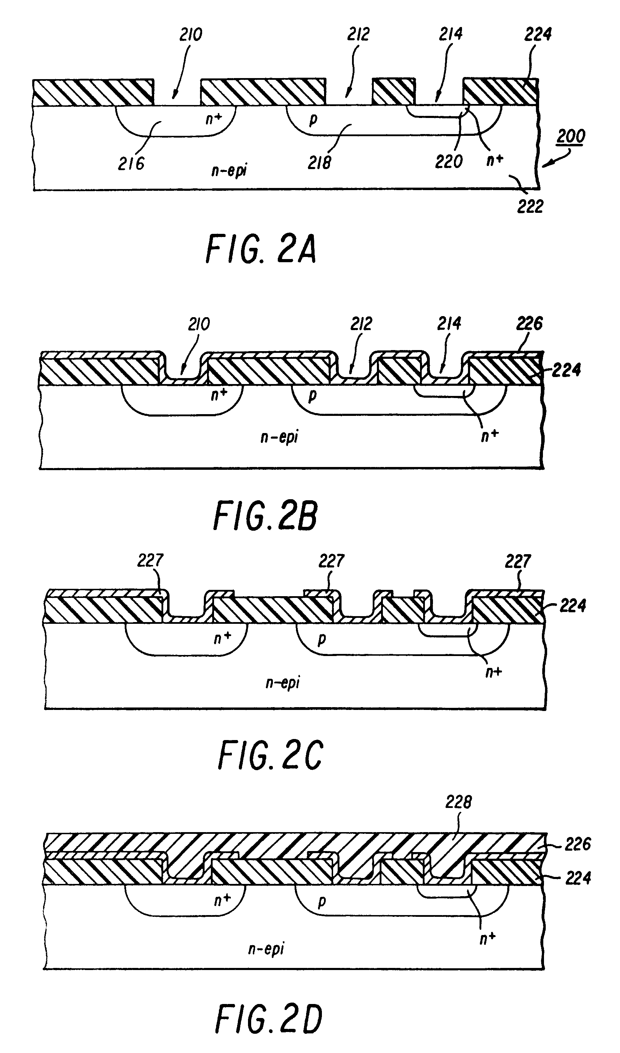

Referring now to Figure 2, there is shown, in diagrammatic form, the processing stages of an alternate preferred method for constructing a device in accordance with the present invention. Depicted in Figure 2A, in diagrammatic cross-sectional form, is a bipolar transistor device, generally designated 200, which has been fabricated to the point at which metal contacts are to be formed, such as that depicted in Figure 1A. Contact regions 210, 212 and 214 are created over n+, p and n+ regions 216, 218 and 220 respectively, having been formed in an n- epi layer 222 of the device, by forming apertures in a silicon dioxide layer 224 which has been disposed over the upper surface of the n- epi layer 222. Once again it should be noted here, as well as in all succeeding examples, that the bipolar device structure selected is exemplary and that the use of the present invention in other MOS or diode structures is deemed to be within the scope and contemplation of the present invention.

Referring now to Figure 2B, a barrier layer 226, comprising a metal nitride, boride or carbide, which forms a stable couple with silicon at temperatures in excess of approximately 500°C, is formed over the silicon dioxide layer 224 into the contact regions 210, 212 and 214, making electrical contact with the underlying doped regions. The barrier layer material is preferably a refractory metal nitride, boride or carbide of such metals as tungsten, molybdenum, tantalum or titanium. Note also, that in accordance with Table I, niobium, zirconium, vanadium and chromium can also be used. The barrier layer may be formed by any known deposition techniques, such as chemical vapor deposition (CVD), sputtering, physical evaporation or ion beam deposition.

Referring to Figure 2C, a pattern of interconnects 227 is defined in the barrier layer 226 utilizing, for example, standard plasma etching techniques. In the preferred process, a layer of photoresist is spun onto the barrier layer 226 then exposed and developed to define the desired interconnect pattern. The barrier metal layer is then dry etched with a flourine or chloride based plasma which selectively attacks the barrier layer material. Although this approach removes the attractiveness of self-alignment of the barrier material to the contact holes, it is completely acceptable in many device applications. The interconnects 227 formed by the patterned barrier layer 226, are then coated with an insulating layer 228, preferably PVX, which is then planarized as depicted in Figure 2D. The planarization is preferably implemented utilizing the technique previously described in conjunction with Figure 1G and 1H.

Once the upper surface of the insulating layer 228 is planarized, via holes can be generated in the layer 228 by etching and a refractory material can thereafter be deposited and patterned forming vias. This enables the formation of an additional interconnect layer in a manner similar to that described with respect to the previous embodiment in conjunction with Figure 1I. In a manner similar to the previously described, a vertical multi-level interconnect structure can be fabricated.

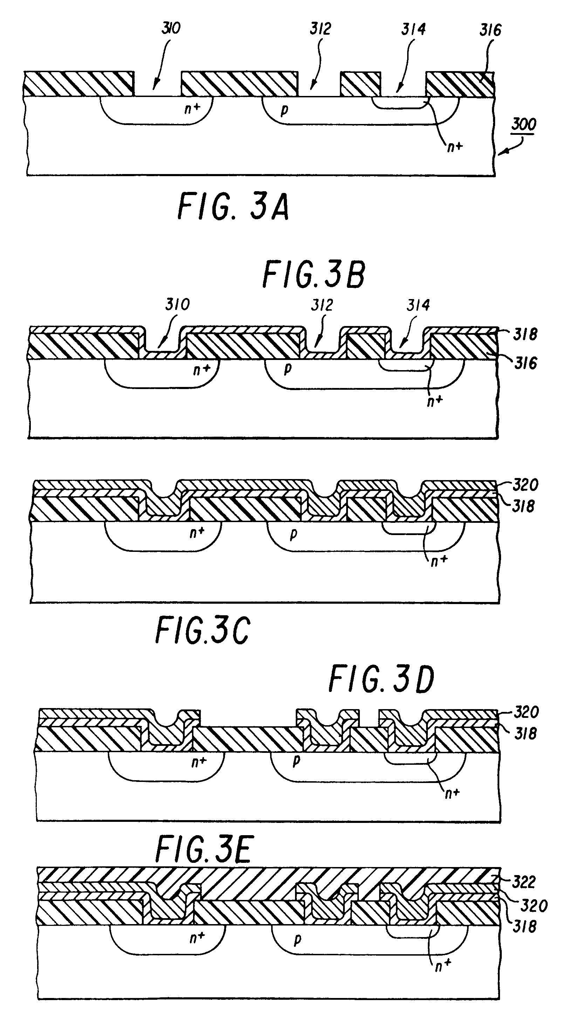

Referring now to Figure 3, there is shown, in diagrammatic form, the processing stages of yet another alternate preferred method for constructing a device in accordance with the present invention. Once again, the description of this alternate preferred method begins with a bipolar transistor device, generally designated 300, having contact regions 310, 312 and 314 formed in a silicon dioxide insulating layer 316. A barrier layer 318 is deposited over the silicon dioxide layer 316 into the contact regions 310, 312 and 314, making contact with the underlying doped regions of the silicon epi layer. As in the previously described embodiments, the barrier layer 318 is preferably a refractory metal nitride, boride or carbide material which forms a stable couple with silicon at elevated temperatures in excess of approximately 500°C. The barrier layer 318 is deposited utilizing known techniques such as CVD, sputtering, physical evaporation or ion beam deposition. The structure of Figure 3 does not result in self aligned barrier and silicide layers.

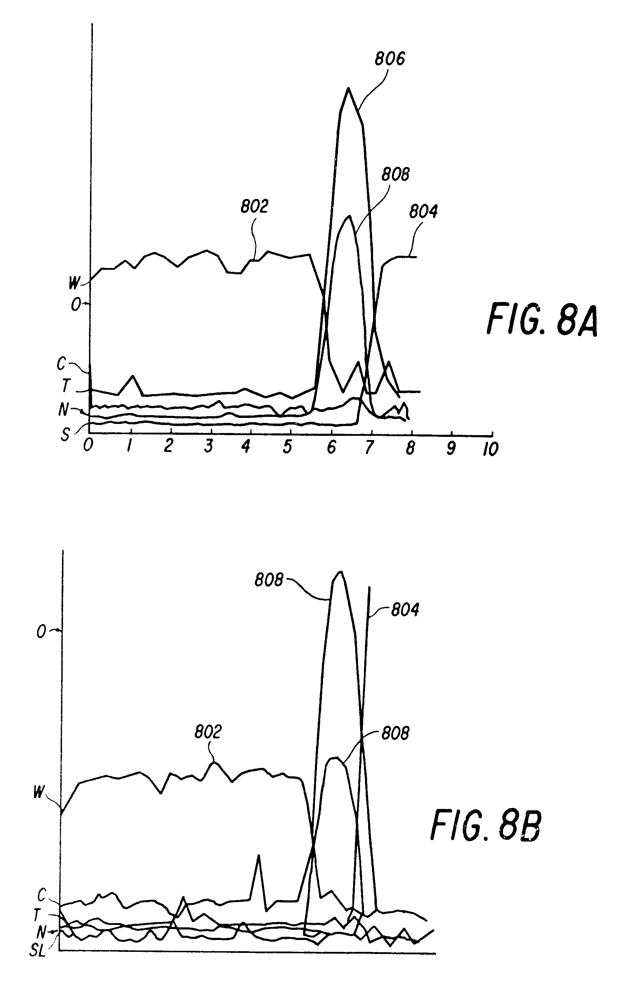

As shown in Figure 3C, an electrically conductive interconnect layer 320 is formed over the barrier layer 318. The electrically conductive interconnect layer 320 consists in a refractory metal having a relatively low resistivity, for example tungsten. It has been found in this structure that the tungsten does not interpenetrate the barrier layer, constructed for example using tantalum nitride, and silicon transport is similarly inhibited by the barrier layer. Figures 8A and 8B are Auger depth profiles of a tungsten/tantalum nitride/silicon structure in accordance with one embodiment of the present invention. Figure 8A is the depth profile of the structure before heating and Figure 8B is the depth profile of the structure after baking at 950°C for thirty minutes. As can be seen in Figure 8B, there is little silicon penetration into the tungsten layer and vice versa. This yields a structure which is of relatively low resistivity, approximately equal to 8-15 micro-ohm centimeters.

As shown in Figure 3D, an interconnect pattern is defined in the interconnect layer 320 and underlying barrier layer 318 utilizing, for example, standard plasma etching techniques similar to those described with respect to the previous embodiments. Referring to Figure 3E, the resulting structure is coated with a layer of insulating material 322, such as PVX glass, which is subsequently planarized in a manner previously described with respect to the preceeding alternate embodiments. The structure is then ready for fabrication of subsequent interconnect layers as previously described with respect to the preceeding alternate embodiment.

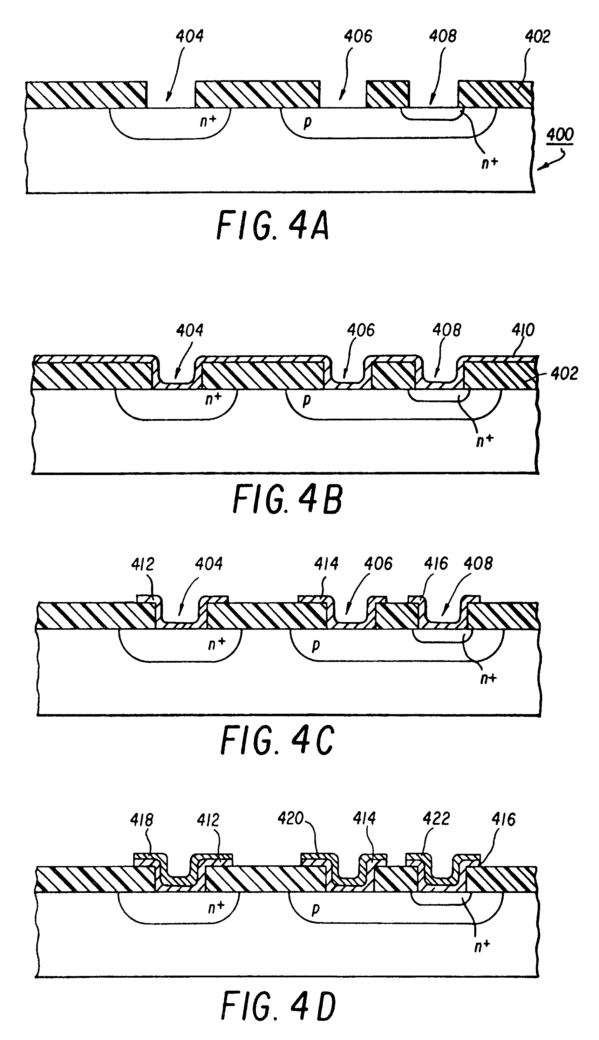

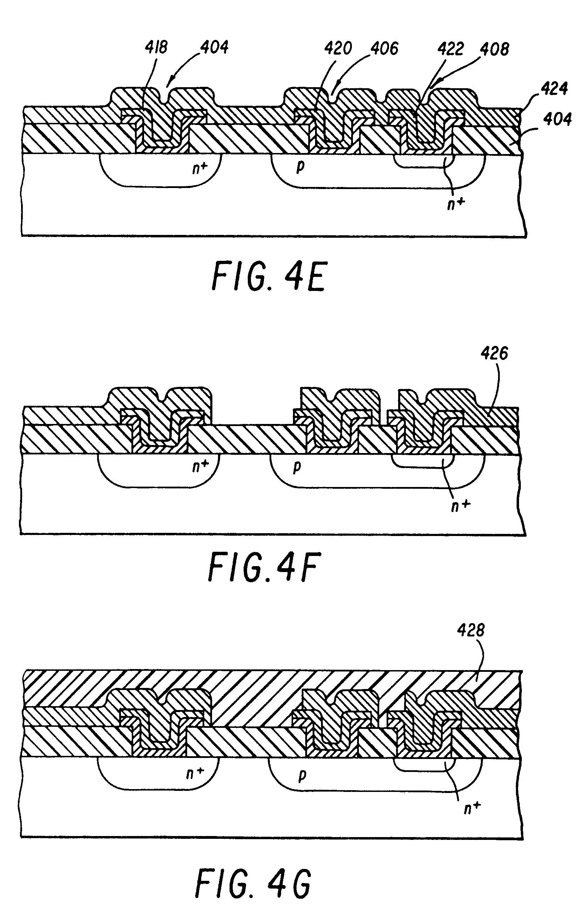

Referring now to Figure 4, there is shown still another alternate preferred method for constructing a device in accordance with the present invention, once again starting with a bipolar transistor device, generally designated 400, which has been fabricated to the point at which metal contacts are to be formed. As depicted in Figure 4A, the device 400 includes a silicon dioxide insulating layer 402 into which contact regions 404, 406 and 408 have been formed. As shown in Figure 4B, a refractory metal disilicide layer 410 is formed over the silicon dioxide insulating layer 402 into the contact regions 404, 406 and 408 utilizing known deposition techniques such as chemical vapor deposition, sputtering, physical evaporation or ion beam deposition. The refractory metal disilicide layer 410 contacts the doped regions underlying the contact regions 406, 408 and 410. The refractory metal disilicide layer 410 is then patterned and etched, utilizing known photoresist and etching techniques, leaving islands 412, 414 and 416, in and around the contact regions 404, 406 and 408 respectively as shown in Figure 4C. Referring to Figure 4D, barrier layers 418, 420 and 422 are formed in islands 412, 414 and 416 respectively, preferably by either implanting boron, nitrogen or carbon into the refractory metal disilicide or placing the structure in a reactive ambient of boron, nitrogen or carbon, resulting in barrier layers comprising refractory metal borides, nitrides or carbides respectively. The ambient is preferred to seal off the edges of the silicide islands 412, 414 and 416.

Referring to Figure 4E, an electrically conductive interconnect layer 424, consisting in a refractory metal or a refractory metal compound, is formed over the silicon dioxide layer 402 and barrier layers 418, 420 and 422 into the contact regions 404, 406 and 408. The interconnect layer 424 is then patterned into interconnects 426 (see Figure 4F) using etching techniques such as those described with respect to formation of interconnects in previous embodiments. As shown in Figure 4G, PVX insulating layer 428 is then formed over the structure and planarized in preparation for the formation of additional interconnect levels as previously described with respect to other alternate embodiments.

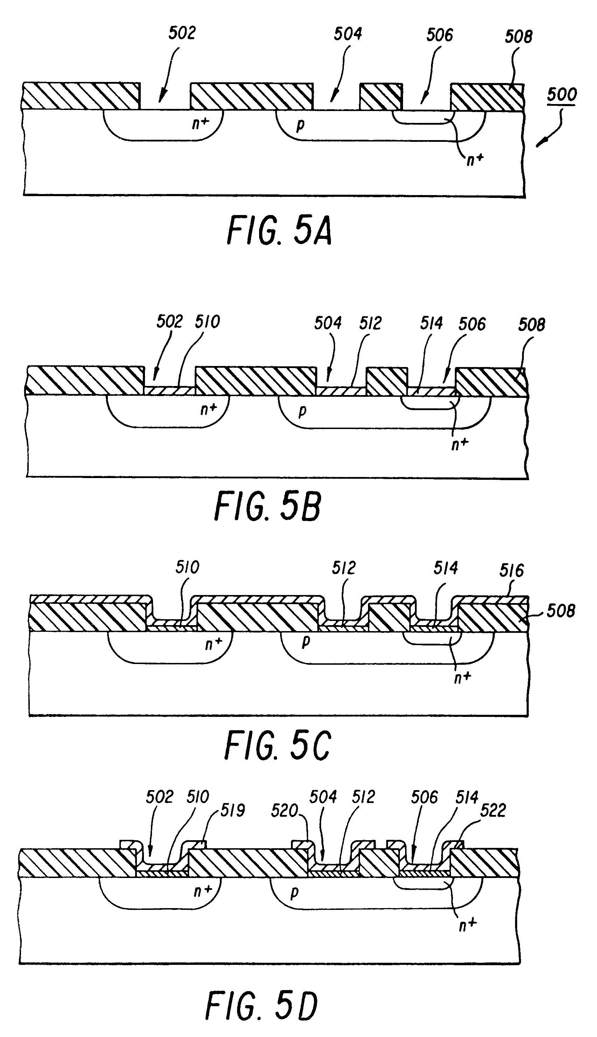

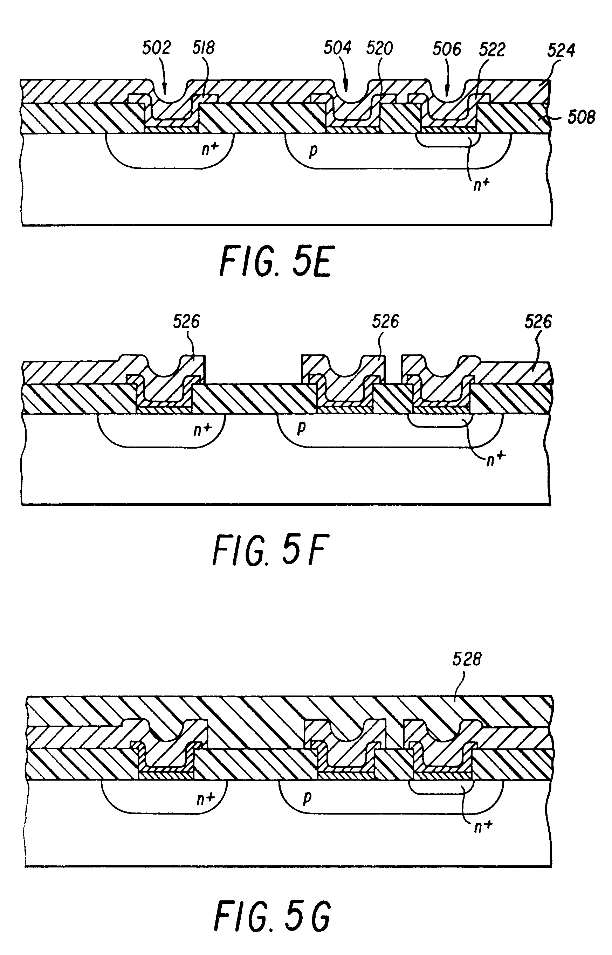

Referring now to Figure 5, there is shown a diagrammatic cross-sectional representation of the processing stages of still another alternate preferred method for constructing a device in accordance with the present invention. Once again, as shown in Figure 5A, the starting point is a bipolar transistor device, generally designated 500, which has been fabricated to the point at which metal contacts are to be formed. The device 500 has contact regions 502, 504 and 506 formed in a silicon dioxide layer 508. Referring to Figure 5B, refractory metal disilicide layers, 510, 512 and 514, are formed in contact regions 502, 504 and 506 respectively by, for example, the method described with respect to the first preferred embodiment as depicted in Figure 1A through 1D. These disilicide layers 510, 512 and 514 are in contact with the doped regions underlying the contact regions 502, 504 and 506 respectively. As shown in Figure 5C, a barrier layer 516, preferably comprising a refractory metal nitride, boride or carbide, is deposited over the silicon dioxide layer 508 and the refractory metal disilicide layers 510, 512 and 514, by, for example, chemical vapor deposition, sputtering, physical evaporation or ion beam deposition.

As shown in Figure 5D, the barrier layer 516 is patterned and etched to form islands 518, 520 and 522 over the metal disilicide layers 510, 512 and 514 and around contact regions 502, 504 and 506 respectively. As shown in Figure 5E, an electrically conductive interconnect layer 524 is formed over the silicon dioxide layer 508 and islands 518, 520 and 522, into contact regions 502, 504 and 506 respectively. As shown in Figure 5F, the electrically conductive interconnect layer 524 is patterned and etched to form interconnects 526 using known techniques such as those previously described with respect to other alternate embodiments. The structure is then coated with an insulating layer 528 of, for example PVX glass, which is then planarized as shown in Figure 5G in accordance with the method previously described. The structure is then ready for the formation of additional interconnect layers in accordance with the techniques previously described.

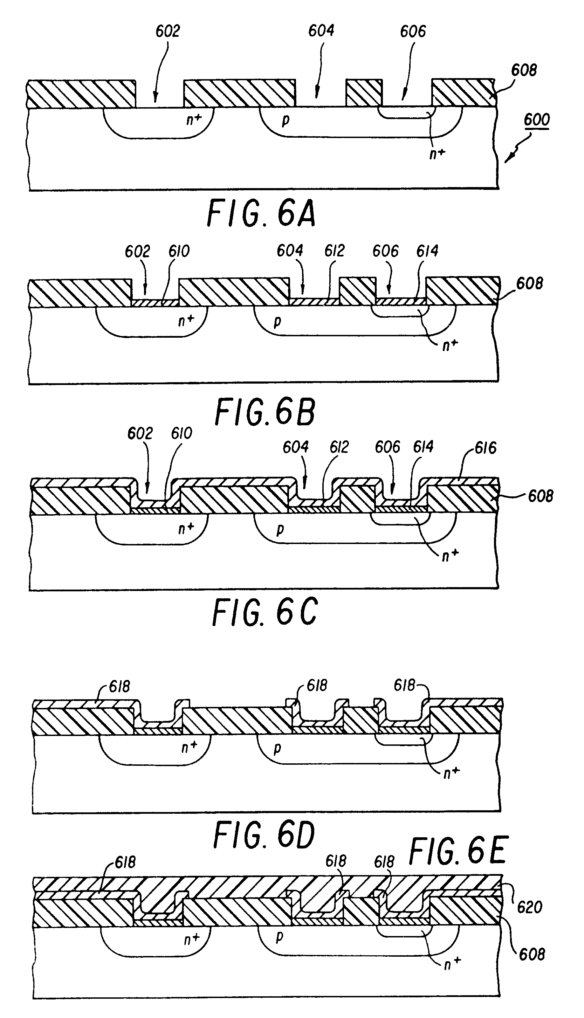

Yet another alternate preferred method for constructing a device in accordance with the present invention is shown, in diagrammatic cross-sectional form, in Figure 6. The description of this alternate embodiment also begins with a bipolar transistor device, generally designated 600, which has been fabricated to the point at which metal contacts are to be formed as shown in Figure 6A. The device 600 has contact regions 602, 604 and 606 formed in a layer of silicon dioxide 608. Referring to Figure 6B, refractory metal disilicide layers 610, 612 and 614 are formed in contact regions 602, 604 and 606 in accordance with the technique previously described with respect to Figure 5B. As shown in Figure 6C, a barrier layer, preferably a refractory metal nitride, boride or carbide, is formed over the silicon dioxide layer 608 and

9

refractory metal disilicide layers 610, 612 and 614 and into contact regions 602, 604 and 606 in accordance with the method previously described with respect to Figure 5C.

As shown in Figure 6D, the barrier layer 616 is then patterned and etched, in accordance with previously described techniques, to form interconnects 618. As shown in Figure 6E, an insulating layer 620, preferably PVX glass, is formed over the interconnect 618 and the silicon dioxide layer 608 then subsequently planarized. The structure is then ready for the fabrication of additional interconnect levels in the manner previously described with respect to alternate preferred embodiments.

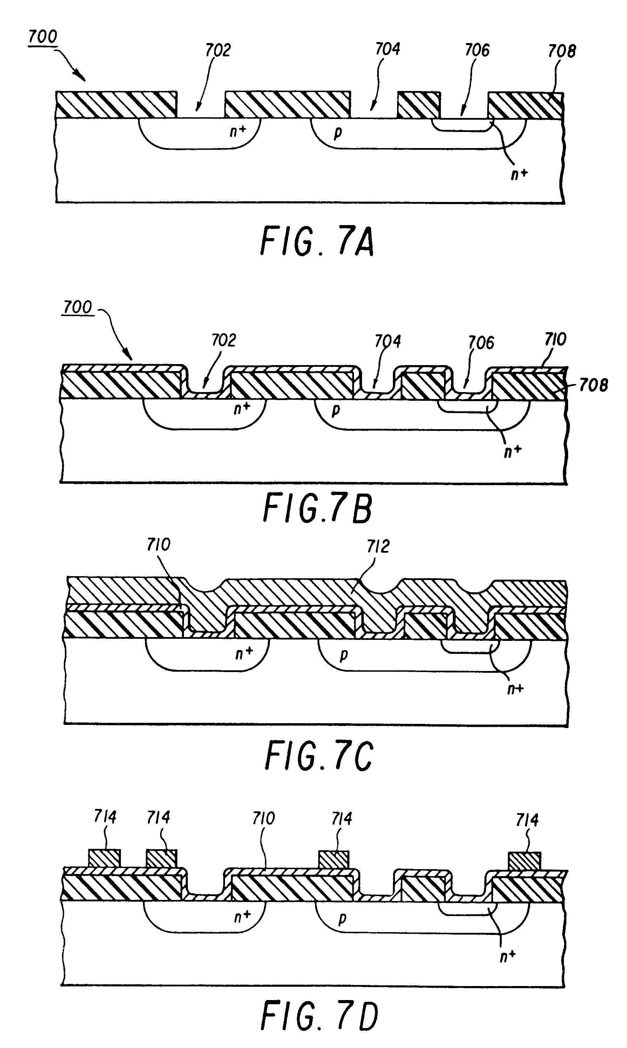

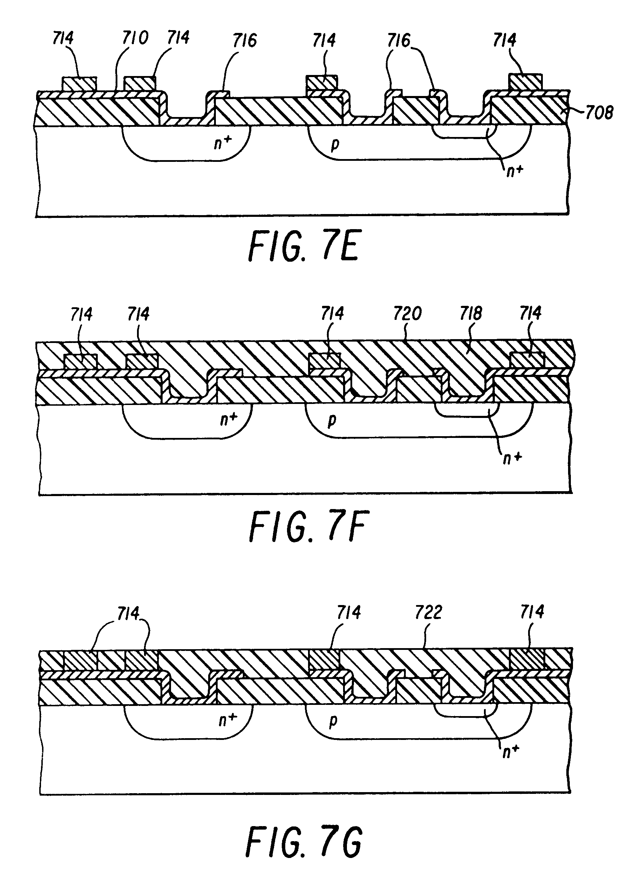

One preferred method for forming multi-layer interconnect structures in accordance with the present invention is shown in Figure 7. The description of this embodiment once again begins with a bipolar transistor device, generally designated as 700, which has been fabricated to the point at which metal contacts are to be formed as shown in Figure 7A. The device 700 has contact regions 702, 704 and 706 formed in a layer of silicon dioxide layer 708 disposed over a doped silicon substrate 709. Referring to Figure 7B, a barrier layer 710, comprising a metal nitride, boride or carbide which forms a stable couple with silicon at temperatures in excess of approximately 500°C, is formed over the silicon dioxide layer 708 into the contact regions 702, 704 and 706, making electrical contact with the underlined doped regions of the substrate 709. The composition of the barrier layer as well as the method of its formation over the silicon dioxide layer is the same as that described with respect to Figure 2B.

Referring to Figure 7C, a layer 712, of a refractory metal such as tungsten, is formed over the barrier layer 710. The layer 712 is then masked, using conventional photoresist techniques, in order to define a desired pattern of vertical posts or vias therein. After the desired via pattern is formed, the refractory metal layer 712 is then etched, using an etchant which reacts with tungsten but not with the barrier layer material in any substantial manner. Preferably, an anisotropric etch process is used to define these via structures. Where the refractory metal layer 712 comprises tungsten, a fluorine based dry etchant is utilized. The photoresist mask allows the etching process to produce a pattern of vias in accordance with the predetermined mask pattern. Since the barrier layer does not react with the etchant, the etching process stops at the upper surface of the barrier layer 710 and, as shown in Figure 7D, a predetermined patterns of vias 714 is formed on the barrier layer 710.

Following the formation of the vias 714, and removal of the photoresist used to define them, a second layer of a photoresist material is disposed over the barrier layer 710 and the defined pattern of via posts 714. The photoresist is then exposed in accordance with a predetermined interconnect pattern. The exposed photoresist pattern masks the barrier layer 710 against an etchant which reacts with the barrier layer material (which is preferably a refractory metal nitride, boride or carbide in this embodiment) and not with the via post material (which is preferably tungsten in this embodiment). The unprotected regions of the barrier layer 710 are then etched with the etchant which selectively removes the barrier layer material while not affecting the vias 714. Consequently, the barrier layer 710 is etched around the photoresist mask pattern as well as around the vias 714 down to the silicon dioxide layer 708, thereby forming the desired interconnect pattern 716 with the vias 714 disposed thereon, as shown in Figure 7E.

Since the vias 714 are uneffected by the second etchant, they act as masks which prevents the second etchant from etching the barrier layer material disposed immediately underneath the vias. Consequently, it can be seen that even if the vias are misaligned with respect to the interconnect pattern, the interconnects will automatically be extended to coincide with the misaligned via thereby creating a contact area which is substantially coextensive with the bottom surface area of each via 714.

Referring now to Figure 7F, this structure is coated with a layer of glass, preferably phosphovapox glass (PVX), which layer is thicker than the height of the via posts 714. The entire structure is then heated to a high temperature in the range of 800°C to 1050°C, to enable the glass to flow under surface tension forces in order to smooth the surface topography of the structure as shown in Figure 7F.

Once the upper surface 720 of the glass layer 718 is substantially planarized as shown in Figure 7F, the layer 718 is etched back to form a substantially planar surface 722 which exposes the tops of the vias 714, as shown in Figure 7G. It is preferred that the glass layer etchant be of a fluorine based chemistry ($CHF_3/C_2F_6$ mixture), which has a suitable selectivity of the glass over the via metal. The glass etchant may even react with the via metal as long as the etch rate of the glass is greater than or equal to the etch rate of via metal. A metal layer, which will be used to form a second layer of interconnects, may now be formed over the planar surface 722 of the glass layer 718 and the exposed tops of the vias 714. This metal layer is then formed into the second interconnect layer using conventional photoresist techniques.

Referring now to Figure 8, there is shown Auger depth profiles of an embodiment of the structure utilizing a silicon transport barrier in accordance with the present invention. Figure 8A depicts the depth profile of this structure, which comprises a tantalum nitride barrier layer disposed between a silicon substrate and a tungsten layer formed thereover. Curve 802 represents the depth profile of the tungsten material and curve 804 represents the depth profile of the silicon material. The barrier layer is represented by curves 806 and 808 which are depth profiles of the tantalum and nitrogen respectively. After heating the structure at 950°C for one-half hour, the Auger depth profile of Figure 8b was taken. As can be seen from the tungsten and silicon depth profile curves 802, 804 respectively, there was very little silicon penetration into the tungsten or vice-versa.

As can be seen from these descriptions of the alternate preferred embodiments of the present invention, the barrier layer of the present invention comprises a material which forms a stable couple with silicon at elevated temperatures. That is, the barrier layer prevents the migration of silicon into the contact regions at high temperatures while itself resisting degradation. In other embodiments, the barrier layer forms a barrier between the underlying silicon and the electrically conductive interconnects which, in accordance with the present invention, are formed of refractory metals which do not degrade at elevated temperatures. This high temperature stability permits the utilization of high temperature processing techniques, such as glass reflow planarization, as well as enabling the device to operate at high temperatures without failure or degradation.

As previously stated, as the dimensions of the emitter contacts decrease, the possibility of enhanced current crowding, premature electromigration failure and junction spiking in bipolar transistors becomes more probable. The use of refractory metals as the interconnect material, in accordance with the present invention, is desirable since these metals have greater electromigration resistance than Al and the use of thicker refractory metal lines reduces the effective current density passing through the circuit. The metal nitride, boride or carbide layers provide very good barriers to silicon or metal diffusion during service operation and play an important role in reducing shallow junction spiking. The barrier also eliminates silicide formation since it does not allow the refractory interconnect material to see silicon.

In addition, since the structures of the present invention are able to tolerate high temperature processing, interlayer topographies can be smoothed using PVX reflow techniques. Consequently, although the refractory metallization in accordance with the present invention is thicker than presently used aluminum metallizations, this reflow technique can be used to smooth the rough topographies generated, thereby making multilevel metallization schemes of this nature a reality.

## Claims

1. A method of fabricating a high temperature interconnect structure for electrically connecting doped regions in a silicon substrate of an integrated circuit device, said method comprising the steps of:
   a) creating contact regions on a surface of said device, each contact region exposing at least a portion of an underlying doped region;
   b) disposing an electrically conductive barrier layer into said contact regions and electrically contacting said underlying doped regions, said barrier layer comprising a material selected from the group consisting of a refractory metal nitride, refractory metal boride and refractory metal carbide, characterized by
   c) disposing an electrically conductive interconnect layer over said surface into said contact regions and electrically contacting said barrier layers disposed therein, said interconnect layer consisting in a refractory metal;
   d) forming said interconnect layer into interconnects for electrically interconnecting said doped regions in a predetermined pattern, no other metal being further provided to form said interconnects.

2. The method of claim 1, characterized in that said refractory metal of said barrier layer material is selected from the group consisting essentially of hafnium, zirconium, titanium, tantalum, niobium, vanadium and chromium.

3. The method of claim 1 or 2, characterized by, prior to step b, the additional step of forming a refractory metal, disilicide layer within each contact region, said refractory metal selected, as required to form a stable thermodynamic couple with both the underlying doped region and the subsequently disposed barrier layer, from the group consisting essentially of tungsten, molybdenum, tantalum, niobium, zirconium, titanium, vanadium and chromium.

4. The method of claim 1 characterized in that said refractory metal is selected from the group consisting essentially of hafnium, zirconium, titanium, tantalum, niobium, vanadium, chromium and tungsten.

5. The method of any one of claims 1 to 3, characterized in that said interconnect layer material is a

EP 0 194 950 B1

refractory metal disilicide.

6. The method of claim 5, characterized in that said refractory metal is selected from the group consisting essentially of tungsten, molybdenum, tantalum, niobium, zirconium, titanium, vanadium and chromium.

7. The method of any previous claim, characterized in that said refractory metal is chosen from the group comprising tungsten and molybdenum.

8. The method of claim 3, characterized in that said additional step comprises:
depositing a layer of refractory metal, having a predetermined thickness, into said contact regions; heating said device to a predetermined temperature in order to form said metal disilicide regions in said contact regions; removing substantially all unreacted refractory metal; and heating said device at a predetermined temperature in a gaseous nitrogen, boran and carbon bearing ambient for a predetermined period of time.

9. The method of any one of claims 1 or 8, characterized by the steps of:
forming a layer of refractory metal over an upper surface of said device and into said contact regions on said barrier layer; forming a predetermined interconnect pattern in said refractory metal layer; coating said predetermined interconnect pattern with a layer of an insulating material; and heating the device in order to reflow said insulating layer to form a substantially planar upper surface thereon.

10. The method of claim 9, characterized by the steps of:
forming a predetermined pattern of apertures in said insulating layer in a predetermined alignment scheme with respect to such interconnect pattern; forming a second layer of refractory metal over the upper surface of said insulating layer into the apertures formed therein; and forming a second predetermined interconnect pattern in said second refractory metal layer.

11. The method of claim 10, characterized by the steps of:
forming a predetermined number of interconnect patterns by repeating the steps of claim 10; coating the uppermost predetermined interconnect pattern with a layer of an insulating material; and heating the device in order to reflow said insulating layer to form a substantially planar upper surface thereon.

12. A semiconductor integrated circuit device including a silicon substrate having a predetermined pattern of doped regions formed therein and contact regions disposed on a surface of said device, each contact region exposing at least a portion of an underlying doped region, means for electrically interconnecting said doped regions, electrically conductive barrier means disposed in said contact regions, said barrier means including a barrier layer comprising a material selected from the group consisting of a refractory metal nitride, refractory metal boride and refractory metal carbide, characterized in that said means (44; 320; 424; 524; 712) for electrically interconnecting said doped regions includes a system of electrical interconnects consisting in a refractory metal for electrically interconnecting said doped regions through said barrier layers in said contact regions in accordance with a predetermined pattern, no other metal being further provided to form said interconnects.

13. The device of claim 12, characterized in that said refractory metal is selected from the group consisting essentially of hafnium, zirconium, titanium, tantalum, niobium, vanad ium, chromium and tungsten.

14. The device of claim 12 or 13, characterized by a refractory metal disilicide layer disposed in said contact region between said doped region and said electrical interconnect, said refractory metal selected, as required to form a stabile thermodynamic couple with both the underlying doped region and the overlying electrical interconnect, from the group consisting essentially of tungsten, molybdenum, tantalum, niobium, zirconium, titanium, vanadium and chromium.

15. The device of any one of claims 12 to 14, characterized in that said refractory metal of said barrier layer material is selected from the group consisting essentially of hafnium, zirconium, titanium, tantalum, niobium, vanadium and chromium.

**Revendications**

12

EP 0 194 950 B1

1. Un procédé pour fabriquer une structure d'interconnexion à haute température destinée à relier électriquement entre elles des régions dopées dans un substrat en silicium d'un dispositif à circuit intégré, ledit procédé comprenant les étapes qui consistent à:

a) créer des régions de contact sur une surface dudit dispositif, chaque région de contact exposant une portion d'une région dopée sous-jacente;

b) disposer une couche d'arrêt électriquement conductrice dans lesdites régions de contact et faisant contact électrique avec les régions dopées sous-jacentes, ladite couche d'arrêt comprenant un matériau choisi dans le groupe consistant en du nitrure d'un métal réfractaire, du borure d'un métal réfractaire et du carbure d'un métal réfractaire, ce procédé étant caractérisé en ce qu'il consiste également

c) à disposer une couche d'interconnexion électriquement conductrice sur ladite surface dans lesdites régions de contact et venant en contact électrique avec les couches d'arrêt qui y sont déposées, ladite couche d'interconnexion comprenant un métal réfractaire;

d) à transformer ladite couche d'interconnexion en des interconnexions destinées à relier électriquement entre elles lesdites régions dopées selon une configuration prédéterminée, aucun autre métal étant fourni en supplément pour former lesdites interconnexions.

2. Procédé selon la revendication 1, caractérisé en ce que ledit métal réfractaire dudit matériau de couche d'arrêt est choisi dans le groupe consistant essentiellement en du hafnium, du zirconium, du titane, du tantale, du niobium, du vanadium et du chrome.

3. Procédé suivant la revendication 1 ou 2, caractérisé en ce qu'il consiste, avant l'exécution de l'étape b, à exécuter une étape supplémentaire consistant à former une couche en bisiliciure de métal réfractaire dans chaque région de contact, ledit métal réfractaire étant choisi, en fonction des exigences dictant la formation d'un couple thermodynamique stable avec à la fois la couche dopée sous-jacente et la couche d'arrêt qui y est ensuite déposée, dans le groupe consistant essentiellement en le tungstène, le molybdène, le tantale, le niobium, le zirconium, le titane, le vanadium et le chrome.

4. Procédé suivant la revendication 1, caractérisé en que ledit métal réfractaire est choisi dans le groupe consistant essentiellement en le hafnium, le zirconium, le titane, le tantale, le niobium, le vanadium ,le chrome et le tungstène.

5. Procédé selon l'une quelconque des revendications 1 à 3, caractérisé en ce que ledit matériau de couche d'interconnexion est en bisiliciure de métal réfractaire.

6. Procédé suivant la revendication 5, caractérisé en ce que le métal réfractaire est choisi dans le groupe consistant essentiellement en le tungstène, le molybdène, le tantale, le niobium, le zirconium, le titane, le vanadium et le chrome.

7. Procédé selon l'une quelconque des revendications précédentes, caractérisé en ce que le métal réfractaire est choisi dans le groupe comprenant le tungstène et le molybdène.

8. Procédé selon la revendication 3, caractérisé en ce que ladite étape supplémentaire comprend des opérations qui consistent à déposer une couche d'un métal réfractaire ayant une épaisseur prédéterminée, dans lesdites régions de contact; à chauffer ledit dispositif jusqu'à une température prédéterminée pour former lesdites régions de bisiliciure de métal dans lesdites régions de contact; à enlever à peu près tout le métal réfractaire n'ayant pas réagi; et à chauffer le dispositif jusqu'à une température prédéterminée dans une atmosphère gazeuse contenant de l'azote, du bore ou du carbone pendant une période de temps prédéterminée.

9. Procédé suivant l'une des revendication 1 ou 8, caractérisé en ce qu'il comprend les étapes consistant à former une couche d'un métal réfractaire sur une surface supérieure dudit dispositif et dans lesdites régions de contact sur la couche d'arrêt, à former une configuration d'interconnexions prédéterminée dans ladite couche de métal réfractaire, à revêtir ladite configuration d'interconnexions prédéterminée avec une couche d'un matériau isolant, et à chauffer le dispositif afin de faire s'écouler par refusion ladite couche d'isolation pour former une surface supérieure à peu près plane sur cette couche.

13

**10.** Procédé selon la revendication 9, caractérisé en ce qu'il comprend les étapes consistant à former une configuration prédéterminée d'ouvertures dans ladite couche d'isolation selon un schéma d'alignement prédéterminé par rapport à la configuration d'interconnexions; à former une seconde couche d'un métal réfractaire sur la surface supérieure de ladite couche d'isolation dans les ouvertures qui y sont formées; et à former une seconde configuration d'interconnexions prédéterminée dans ladite seconde couche de métal réfractaire.

**11.** Procédé suivant la revendication 10, caractérisé en ce qu'il comprend les étapes qui consistent à former un nombre prédéterminé de configuration d'interconnexions en répétant les étapes de la revendication 10; à revêtir la configuration d'interconnexions prédéterminée supérieure avec une couche d'un matériau isolant; et à chauffer les dispositifs afin de faire s'écouler par refusion ladite couche d'isolation pour former une surface supérieure à peu près plane sur cette couche.

**12.** Un dispositif semiconducteur à circuit intégré comprenant un substrat en silicium ayant une configuration prédéterminée de régions dopées qui y sont formées et des régions de contact disposées sur une surface du dispositif, chaque région de contact exposant au moins une portion d'une région dopée sous-jacente, des moyens pour relier électriquement entre elles lesdites régions dopées, des moyens d'arrêt électriquement conducteurs disposés dans lesdites régions de contact, lesdits moyens d'arrêt comprenant une couche d'arrêt qui comporte un matériau choisi dans le groupe consistant en du nitrure, du borure ou du carbure d'un métal réfractaire, caractérisé en que lesdits moyens (44; 320; 424; 524; 712) destinés à relier électriquement entre elles lesdites régions de contact, comprennent un système d'interconnexions électriques consistant en un métal réfractaire destiné à relier entre elles électriquement lesdites régions dopées à travers lesdites couches d'arrêt dans lesdites régions de contact selon une configuration prédéterminée, aucun autre métal n'étant fourni en supplément pour former lesdites interconnexions.

**13.** Dispositif suivant la revendication 12, caractérisé en ce ledit métal réfractaire est choisi dans le groupe consistant essentiellement en du hafnium, du zirconium, du titane, du tantale, du niobium, du vanadium, du chrome et du tungstène.

**14.** Dispositif suivant la revendication 12 ou 13, caractérisé en ce qu'une couche de bisiliciure d'un métal réfractaire est déposée dans ladite région de contact entre ladite région dopée et ladite interconnexion électrique, ledit métal réfractaire étant choisi, selon les exigences dictant la formation d'un couple thermodynamique stable avec à la fois la région dopée sous-jacente et l'interconnexion électrique sur-jacente, dans le groupe consistant essentiellement en du tungstène, du molybdène, du tantale, du niobium, du zirconium, du titane, du vanadium et du chrome.

**15.** Dispositif l'une quelconque des revendication 12 à 14, caractérisée en ce que ledit métal réfractaire dudit matériau de couche d'arrêt est choisi dans le groupe consistant essentiellement en du hafnium, du zirconium, du titane, du tantale, du niobium, du vanadium et du chrome.

**Patentansprüche**

**1.** Ein Verfahren der Herstellung einer hochtemperaturfesten Netzstruktur für die elektrische Verbindung dotierter Bereiche in einem Siliciumsubstrat eines integrierten Schaltkreises, welches Verfahren die Schritte umfaßt:
a) Erzeugen von Kontaktbereichen auf einer Oberfläche des Schaltkreises, wobei jeder Kontaktbereich mindestens einen Abschnitt eines darunterliegenden dotierten Bereiches exponiert,
b) Anordnen einer elektrisch leitenden Barriereschicht in den Kontaktbereichen unter Ausbildung elektrischen Kontaktes mit den darunterliegenden dotierten Bereichen, welche Barriereschicht ein Material umfaßt, ausgewählt aus der Gruppe bestehend aus einem Nitrid, Borid und Karbid eines hochtemperaturfesten Metalls, gekennzeichnet durch
c) Anordnen einer elektrisch leitenden Netzschicht über der Oberfläche in den Kontaktbereichen unter elektrischem Kontaktieren der Barriereschichten, die dort angeordnet sind, welche Netzschicht aus einem hochtemperaturfesten Metall besteht,
d) Bilden von Netzen aus der Netzschicht für die elektrische Verbindung der dotierten Bereiche in einem vorbestimmten Muster, wobei kein anderes Metall weiter für die Ausbildung dieser Verbindungen vorgesehen ist.

**2.** Das Verfahren nach Anspruch 1, dadurch gekennzeichnet, daß das hochtemperaturfeste Metall des Barrierschichtmaterials ausgewählt ist aus der Gruppe bestehend im wesentlichen aus Hafnium, Zirkon, Titan, Tantal, Niob, Vanadium und Chrom.

**3.** Das Verfahren nach Anspruch 1 oder 2, gekennzeichnet durch den vor Schritt b) erfolgenden zusätzlichen Schritt der Bildung einer Disilicidschicht eines hochtemperaturfesten Metalls innerhalb jedes Kontaktbereichs, welches hochtemperaturfeste Metall ausgewählt wird entsprechend dem Erfordernis der Bildung eines stabilen thermodynamischen Paares sowohl mit dem darunterliegenden dotierten Bereich als auch der nachfolgend aufgebrachten Barriereschicht aus der Gruppe bestehend im wesentlichen aus Wolfram, Molybdän, Tantal, Niob, Zirkon, Titan, Vanadium und Chrom.

**4.** Das Verfahren nach Anspruch 1, dadurch gekennzeichnet, daß das hochtemperaturfeste Metall ausgewählt wird aus der Gruppe bestehend im wesentlichen aus Hafnium, Zirkon, Titan, Tantal, Niob, Vanadium, Chrom und Wolfram.

**5.** Das Verfahren nach einem der Ansprüche 1 bis 3, dadurch gekennzeichnet, daß das Material der Netzschicht ein Disilicid eines hochtemperaturfesten Metalls ist.

**6.** Das Verfahren nach Anspruch 5, dadurch gekennzeichnet, daß das hochtemperaturfeste Metall ausgewählt wird aus der Gruppe bestehend im wesentlichen aus Wolfram, Molybdän, Tantal, Niob, Zirkon, Titan, Vanadium und Chrom.

**7.** Das Verfahren nach einem der vorangehenden Ansprüche, dadurch gekennzeichnet, daß das temperaturfeste Metall gewählt wird aus der Gruppe, die Wolfram und Molybdän umfaßt.

**8.** Das Verfahren nach Anspruch 3, dadurch gekennzeichnet, daß der zusätzliche Schritt umfaßt:
Anordnen einer Schicht aus hochtemperaturfestem Metall mit einer vorbestimmten Dicke in den Kontaktbereichen, Erhitzen des Schaltkreises auf eine vorbestimmte Temperatur zur Ausbildung der Metalldisilicidbereiche in den Kontaktbereichen; Abtragen im wesentlichen des gesamten nichtreagierten hochtemperaturfesten Metalls und Erhitzen des Schaltkreises auf eine vorbestimmte Temperatur in einer gasförmigen Stickstoff, Bor und Kohlenstoff enthaltenden Umgebung während einer vorbestimmten Zeitperiode.

**9.** Das Verfahren nach einem der Ansprüche 1 oder 8, gekennzeichnet durch die Schritte:
Bilden einer Schicht aus einem hochtemperaturfesten Metall über einer oberen Oberfläche des Schaltkreises und in den Kontaktbereichen auf der Barriereschicht; Bilden eines vorbestimmten Netzmusters in der Schicht aus hochtemperaturfestem Metall; Beschichten des vorbestimmten Netzmusters mit einer Schicht aus einem Isoliermaterial und Erhitzen des Schaltkreises zum Rückfließenlassen der Isolierschicht zur Ausbildung einer im wesentlichen planaren oberen Oberfläche darauf.

**10.** Das Verfahren nach Anspruch 9, gekennzeichnet durch die Schritte:
Bilden eines vorbestimmten Musters von Öffnungen in der Isolierschicht in einem vorbestimmten Ausfluchtungsschema bezüglich des Netzmusters; Bilden einer zweiten Schicht aus hochtemperaturfestem Metall über der oberen Oberfläche der Isolierschicht in die darin ausgebildeten Öffnungen und Bilden eines zweiten vorbestimmten Netzmusters in der zweiten Schicht aus hochtemperaturfestem Metall.

**11.** Das Verfahren nach Anspruch 10, gekennzeichnet durch die Schritte:
Bilden einer vorbestimmten Anzahl von Netzmustern durch Wiederholen der Schritte des Anspruchs 10; Beschichten des obersten vorbestimmten Netzmusters mit einer Schicht eines Isoliermaterials und Erhitzen des Schaltkreises zum Rückfließenlassen der Isolierschicht zwecks Ausbildung einer im wesentlichen planaren oberen Oberfläche darauf.

**12.** Ein integrierter Halbleiterschaltkreis mit einem Siliciumsubstrat, das ein vorbestimmtes Muster dotierter Bereiche, die darin ausgebildet sind, aufweist, sowie Kontaktbereiche auf einer Oberfläche des Schalktkreises aufweist, wobei jeder Kontaktbereich zumindest einen Abschnitt eines darunterliegenden dotierten Bereichs exponiert, Mittel für das elektrische Verbinden der dotierten Bereiche, elektrisch leitende Barrieremittel, die in den Kontaktbereichen angeordnet sind, welche Barrieremittel eine Barrie-

reschicht umfassen, die ein Material umfaßt, ausgewählt aus der Gruppe bestehend aus einem Nitrid, Borid und Karbid eines hochtemperaturfesten Metalls, dadurch gekennzeichnet, daß die Mittel (44; 320; 424; 524; 712) für das elektrische Verbinden der dotierten Bereiche ein System von elektrischen Netzen umfassen, bestehend aus einem hochtemperaturfesten Metall für die elektrische Verbindung der dotierten Bereiche durch die Barriereschichten in den Kontaktbereichen hindurch in Übereinstimmung mit einem vorbestimmten Muster , wobei kein anderes Metall weiterhin vorgesehen ist für die Bildung der Netze.

13. Der Schaltkreis nach Anspruch 12, dadurch gekennzeichnet, daß das hochtemperaturfeste Metall ausgewählt ist aus der Gruppe bestehend im wesentlichen aus Hafnium, Zirkon, Titan, Tantal, Niob, Vanadium, Chrom und Wolfram.

14. Der Schaltkreis nach Anspruch 12 oder 13, gekennzeichnet durch eine Disilicidschicht eines hochtemperaturfesten Metalls, angeordnet in dem Kontaktbereich zwischen dem dotierten Bereich und dem elektrischen Netz, welches hochtemperaturfeste Metall ausgewählt wird entsprechend dem Erfordernis der Bildung eines stabilen thermodynamischen Paares mit sowohl dem darunterliegenden dotierten Bereich als auch dem darüberliegenden elektrischen Netz aus der Gruppe bestehend im wesentlichen aus Wolfram, Molybdän, Tantal, Niob, Zirkon, Titan, Vanadium und Chrom.

15. Der Schaltkreis nach einem der Ansprüche 12 bis 14, dadurch gekennzeichnet, daß das hochtemperaturfeste Metall des Barriereschichtmaterials ausgewählt ist aus der Gruppe bestehend im wesentlichen aus Hafnium, Zirkon, Titan, Tantal, Niob, Vanadium und Chrom.

**FIG. 1A**

**FIG. 1B**

**FIG. 1C**

FIG. 1D

FIG. 1E

FIG. 1F

FIG. 1G

FIG. 1H

FIG. 1I

FIG. 2A

FIG.2B

FIG.2C

FIG.2D

FIG. 3A

FIG.3B

FIG.3C

FIG. 3D

FIG.3E

404          406        408        402

$n^+$      $p$

400

$n^+$

## FIG. 4A

404          406        408        410

402

$n^+$      $p$

$n^+$

## FIG. 4B

412  404      414  406    416  408

$n^+$      $p$

$n^+$

## FIG. 4C

418  412    420  414    422  416

$n^+$      $p$

$n^+$

## FIG. 4D

FIG. 4E

FIG.4F

FIG. 4G

FIG. 5A

FIG. 5B

FIG. 5C

FIG. 5D

FIG. 5E

FIG. 5F

FIG. 5G

602    604    606

608

600

n+    p

n+

FIG. 6A

602  610    604  612  606  614

608

n+    p

n+

FIG. 6B

602  610    604  612  606  614    616

608

n+    p

n+

FIG. 6C

618    618    618

n+    p

n+

FIG. 6D

FIG. 6E

618    618  618

620

n+    p

608

n+

FIG. 7A

FIG. 7B

FIG. 7C

FIG. 7D

*FIG. 7E*

*FIG. 7F*

*FIG. 7G*

FIG. 8A

FIG. 8B